# FASCICULE DE BREVET EUROPEEN

(11) **EP 1 290 498 B1**
(45) Date de publication et mention de la délivrance du brevet: **17.03.2004**
(21) Numéro de dépôt: 01945431.3
(22) Date de dépôt: 14.06.2001
(51) Int. Cl.: G03F 7/00

(54) **PROCEDE DE CREATION D'UN ETAGE DE CIRCUIT INTEGRE OU COEXISTENT DES MOTIFS FINS ET LARGES**
VERFAHREN ZUR HERSTELLUNG EINER SCHICHT IN EINEM INTEGRIERTEN SCHALTKREIS MIT FEINEN UND BREITEN STRUKTUREN
METHOD FOR CREATING AN INTEGRATED CIRCUIT STAGE WHEREIN FINE AND LARGE PATTERNS COEXIST

(30) Priorité: 16.06.2000 FR 0007718
(43) Date de publication de la demande: 12.03.2003
(73) Titulaire: COMMISSARIAT A L'ENERGIE ATOMIQUE, 75752 Paris Cédex 15 (FR)
(72) Inventeur: DELEONIBUS, Simon, F-38640 Claix (FR)
(74) Mandataire: Ilgart, Jean-Christophe
(86) Numéro de dépôt international: PCT/FR2001/001850
(87) Numéro de publication internationale: WO 2001/096957

(56) Documents cités:
- EP-A- 0 779 556
- US-A- 4 612 274
- US-A- 5 670 423

## Description

Le sujet de cette invention est un procédé de création d'un étage de circuit intégré où coexistent des motifs fins et des motifs larges, notamment semi-conducteurs.

Il est connu de graver des couches semiconductrices pour ne laisser subsister que des motifs isolés qui feront partie du circuit intégré. On y parvient notamment en déposant un masque dur sur la couche semi-conductrice, qu'on fait ensuite disparaître sur les portions à graver de manière qu'il soustraie les motifs à préserver de la gravure. On recourt en général à une autre étape de gravure pour enlever le masque aux endroits inutiles, après avoir déposé de la résine sur les portions du masque qu'il convient de protéger. La résine est déposée en couche continue qui est exposée, c'est-à-dire soumise à des conditions qui la sensibilisent, soit sur les portions à protéger du masque, soit sur les autres portions, selon qu'on a affaire à une résine appelée « négative » ou « positive ». Une étape de développement de la résine enlève ensuite celle-ci ailleurs que sur les portions à protéger du masque. Enfin, le reste de la résine est enlevé quand le masque a été gravé.

Il existe deux procédés principaux pour exposer la résine : les rayonnements, notamment lumineux aux ultraviolets ou aux rayons X, et les bombardements de particules, notamment d'électrons ou aussi d'ions, etc. souvent réalisés par un balayage d'un faisceau. Selon leur composition, les résines sont en pratique sensibles à l'un ou l'autre de ces procédés. Les rayonnements permettent d'exposer la résine de manière collective et donc de tracer les motifs en une fois. Par contre, on constate qu'ils ne permettent pas d'obtenir ensuite des motifs semi-conducteurs avec une grande précision de dimensions, ce qui les rend inadaptés quand les motifs qu'il faut faire apparaître sont fins, car les incertitudes deviennent alors excessives.

Les bombardements de particules permettent au contraire de réaliser des motifs avec une grande précision mais n'exposent la résine que lentement, le faisceau devant être déplacé peu à peu au-dessus de toute la surface à exposer. Quand des motifs larges et fins coexistent, l'utilisation générale du bombardement de particules, pourtant rendu nécessaire par la présence des motifs fins, conduit à des temps de fabrication excessifs.

Il est donc utile de permettre dans ce secteur technique l'utilisation conjointe des rayonnements et des bombardements de particules pour former respectivement les motifs larges et fins (typiquement, de 100 nm et 20 nm de largeurs respectives) de l'étage de circuit intégré, sans que l'application du rayonnement n'ait d'effet néfaste sur la formation des motifs fins, et en réservant le bombardement de particules aux motifs fins afin de ne pas accroître le temps de fabrication de l'étage plus qu'il n'est nécessaire.

Un article de Tedesco et autres « Resist process of hybrid (electron-beam / deep ultraviolet) lithography » paru dans le Journal of Vacuum Science and Technology, B16(6), novembre-décembre 1998, p.3676-3683, mentionne la possibilité d'user d'une résine « mixte », pouvant être exposée à la fois aux rayonnements et aux faisceaux de particules ; mais de telles résines ne sont optimales ni pour un procédé d'exposition ni pour l'autre.

L'utilisation de masques durs à la place de la résine a aussi été proposée pour permettre de graver des motifs fins avec précision ; mais les résines restent d'emploi plus commode.

Le brevet EP-A-0 779 556 concerne un procédé de création d'un étage de circuit intégré comprenant des motifs, notamment semi-conducteurs, dont des premiers ont des largeurs supérieures à un seuil et des seconds ont des largeurs inférieures au seuil, consistant à déposer une couche de matière des motifs sur un substrat, un masque sur la couche de matière des motifs, puis, une couche supérieure sur le masque, une première résine qui est exposée et developpée en subsistant seulement sur les premiers motifs encore à former, à graver la couche supérieure, à éliminer la première résine, à déposer une seconde résine qui est exposée et développée en subsistant sur les seconds motifs encore à former, à graver le masque où il est apparent, à graver la couche de matière des motifs, formant ainsi les premiers et les seconds motifs, où elle est apparente, et à enlever la seconde résine.

Certains des premiers motifs peuvent être jointifs à certains des seconds motifs. Conformément à ce qu'on a déjà exposé, la première résine est en général sensibilisée par une exposition à un rayonnement et la seconde résine est sensibilisée par une exposition à un bombardement de particules. Avant de procéder à la gravure de la couche supérieure dans le premier cas, à la gravure de la couche de matière des motifs dans le deuxième cas, on procède au développement de la résine exposée.

La couche supérieure est avantageusement en la matière des motifs et complètement enlevée quand la couche de matière des motifs est gravée.

On entend perfectionner un procédé tel que celui de ce brevet EP-A-0 779 556 par des étapes qui consistent à graver le masque là où il est apparent après avoir gravé la couche supérieure, puis à déposer un second masque après avoir enlevé la première résine, et à graver le second masque là où il est apparent après avoir déposé la seconde résine.

En effet, le second masque peut former des flancs autour de reliquats du premier masque déposé sur la couche des matières des motifs, et ces flancs subsistent jusqu'à ce que la couche de matière des motifs est gravée.

Un effet de ce procédé particulier est que les premiers motifs peuvent être formés avec une base élargie sous les flancs du second masque, ce qui est avantageux si ces motifs sont des transistors MOS.

Un autre effet est que les flancs maintiennent la largeur des motifs larges en les prémunissant contre les attaques latérales qui les auraient étrécis à la gravure de la couche de matière des motifs.

L'invention sera décrite plus en détail au moyen de réalisations pratiques exposées à titre non exhaustif dans les figures suivantes :
- les figures 1A à 1F sont les étapes d'un déroulement d'un procédé général de création de motifs larges et fins, sur lequel l'invention ne porte pas,
- les figures 2A et 2B sont deux vues de motifs typiques raccordés,
- et les figures 3A et 3E illustrent le déroulement d'un procédé caractéristique de l'invention.

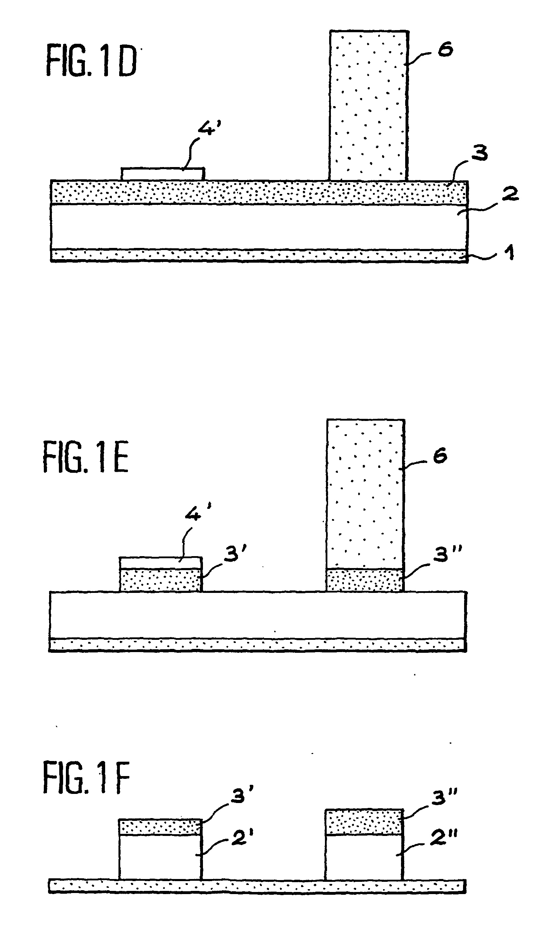

Sur la figure 1A il a été déposé sur un substrat 1, pouvant consister en une couche d'arrêt en oxyde de silicium (SᵢO₂), une couche semi-conductrice 2 pouvant être en silicium polycristallin ou nitrure de silicium dans laquelle devront être gravés des motifs d'une grille semi-conductrice, un masque dur 3 pouvant être en oxyde de silicium a été déposé sur la couche semi-conductrice 2 et une couche supérieure 4 semi-conductrice, éventuellement de même composition que la couche 2, a été déposée sur le masque dur 3.

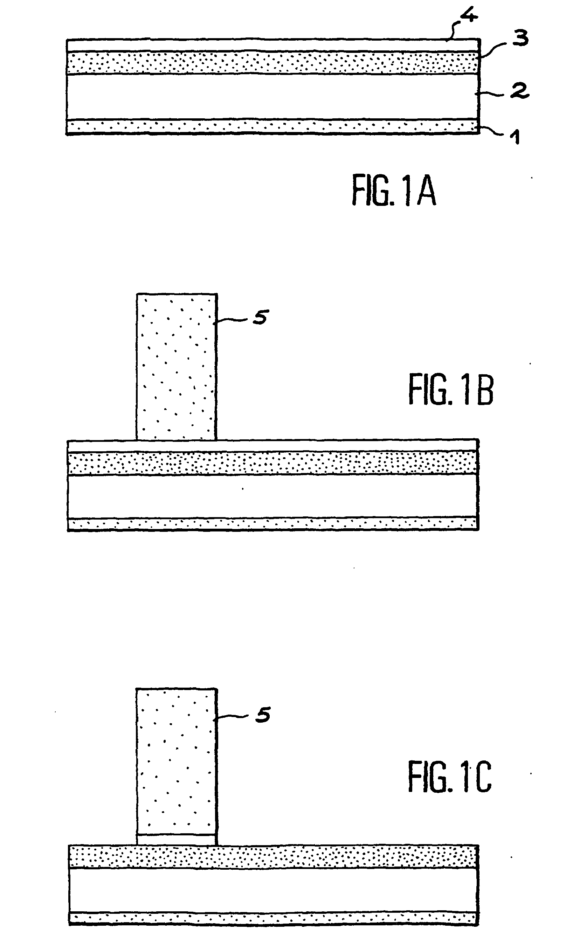

Ensuite, comme le montre la figure 1B, de la résine sensible aux rayonnements 5 est déposée, exposée et développée en subsistant sur les portions de la couche supérieure 4 qui surplomberont les motifs larges à graver dans la couche semi-conductrice 2.

Une première gravure de la couche supérieure 4 est alors entreprise conformément à la figure 1C, sauf aux endroits où elle est recouverte par la résine sensible aux rayonnements 5.

La résine sensible aux rayonnements 5 peut alors être enlevée par une exposition par exemple à un plasma d'oxygène, avant qu'une résine sensible aux particules 6 ne soit déposée sur le masque dur 3, qui a été mis à nu précédemment, puis exposée et développée en ne subsistant qu'au-dessus des motifs fins à graver dans la couche 2. C'est l'état représenté à la figure 1D. Des reliquats 4' de la couche semi-conductrice 4 qui subsistent au-dessus des motifs larges, ne sont pas ou ne sont que peu attaqués quand la résine 6 est développée puis enlevée.

La figure 1E montre que l'étape suivante consiste en une gravure du masque dur 3 là où il est apparent, ne le laissant subsister qu'aux endroits des futurs motifs larges et fins de la couche semi-conductrice 2 ; il y forme des reliquats, respectivement 3' et 3" , qui sont respectivement protégés par les reliquats 4' de la couche semi-conductrice 4 et par la résine sensible aux particules 6.

La figure 1F illustre l'état obtenu à la fin du procédé, après que la résine 6 a été ensuite enlevée par exemple par un plasma d'oxygène, puis enfin que la matière semi-conductrice a été gravée, en ne la laissant subsister qu'aux motifs larges 2' et fins 2'' sous les reliquats 3' et 3" du masque dur, qu'on laisse aussi subsister pour qu'ils produisent une isolation électrique dans le circuit intégré dont la fabrication sera poursuivie par d'autres étapes. On peut employer une gravure chimique anisotrope avec un des produits suivants : HBᵣ, Cl₂, O₂ ou CF₄O₂. Les reliquats 3' des motifs larges 2' peuvent avoir en pratique été quelque peu attaqués et restent alors moins épais que les reliquats 3'' ; cela est pourtant acceptable.

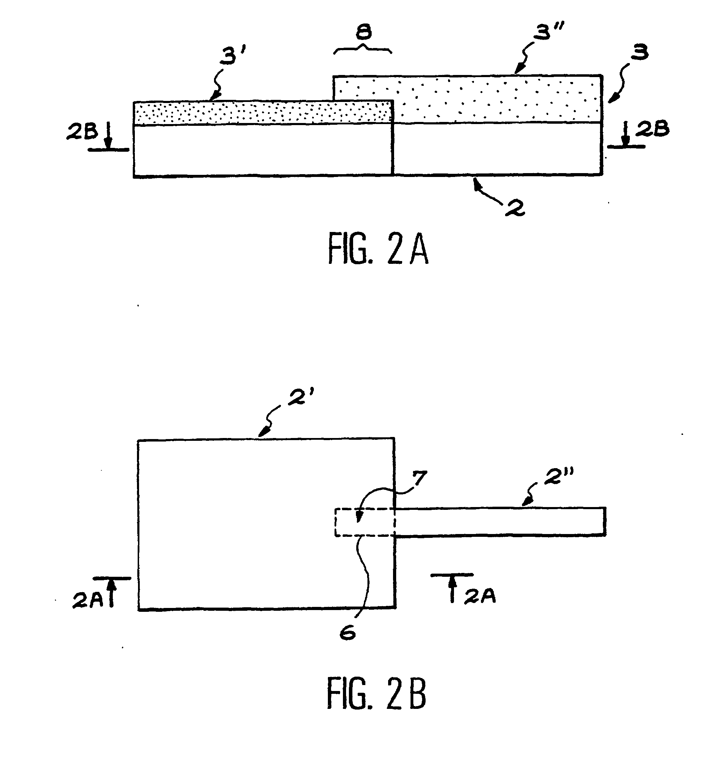

Comme on le voit aux figures 2A et 2B, les motifs larges et fins 2' et 2" peuvent parfaitement être jointifs. Il serait utile alors que la résine sensible aux particules 6 déposée à l'étape de la figure 1D chevauche quelque peu les reliquats 4', ce qu'on a figuré par la portion 7 de la figure 2B. La dénivellation entre les reliquats 3' et 3" est alors séparée de la jonction des motifs 2' et 2" d'une distance de garde 8, ce qui offre un meilleur raccordement.

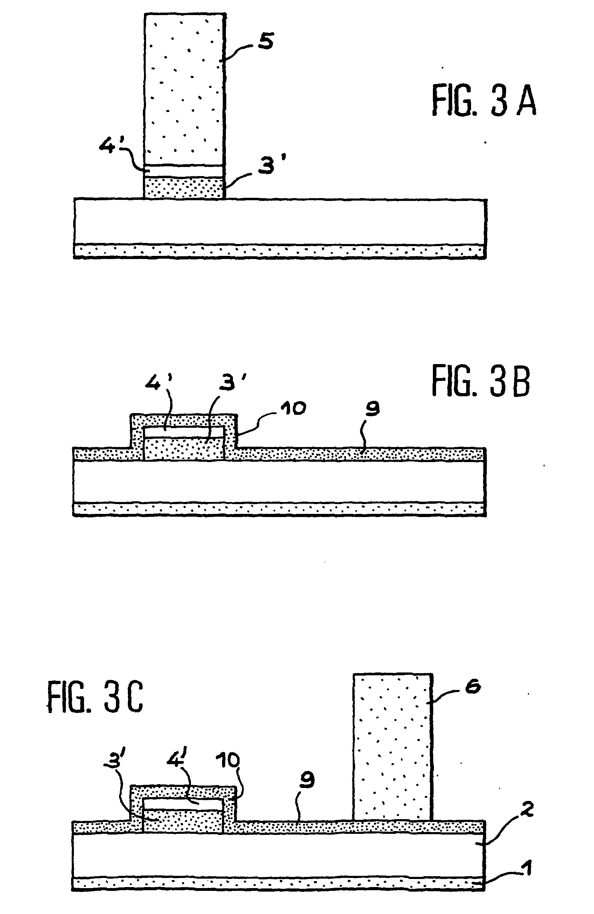

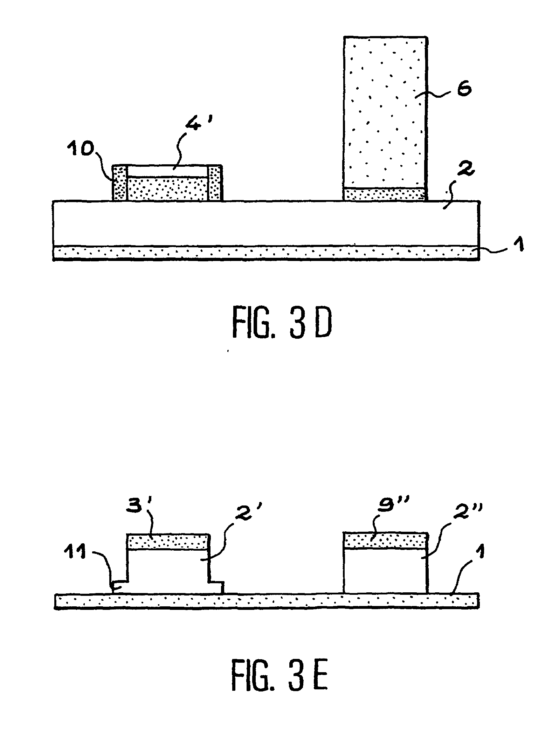

Une réalisation de l'invention sera maintenant décrite à l'aide des figures 3A à 3E.

La figure 3A est obtenue à partir de l'état de la figure 1C après une gravure du masque dur 3 qui n'a laissé subsister que les reliquats 3'. La résine sensible aux rayonnements 5 est alors enlevée, et un second masque 9 est déposé sur toute la structure obtenue alors ; il forme une couche horizontale, sauf en des flancs 10 sensiblement verticaux qui entourent les reliquats 3' et 4' aux emplacements des motifs larges, ce qu'illustre la figure 3B. La figure 3C montre que la résine sensible aux particules 6 est ensuite déposée au-dessus des motifs fins et sur le second masque 9, avant que celui-ci ne soit enlevé ailleurs par une gravure appropriée, sauf toutefois aux flancs 10 qui sont restés abrités, selon l'état de la figure 3D. Les étapes finales du procédé consistent à enlever la résine sensible aux particules 6 et à graver la matière semi-conductrice, ce qui fait disparaître les reliquats 4' et surtout les portions de la couche 2 qui n'étaient pas recouvertes des masques durs. Une certaine attaque des masques durs est cependant produite, qui fait disparaître tout ou partie les flancs 10 tout en laissant subsister une portion au moins des reliquats 3' sur les motifs larges 2' et 9" sur les motifs fins 2'' ; de la même façon, les motifs larges 2'' présentent une base élargie 11 sous les emplacements des anciens flancs 10. Cette base élargie 11 peut être utile si les motifs larges 2' sont destinés à former des transistors MOS à haute tension par exemple. Sinon, il peut être préférable de l'enlever, ce qu'on peut accomplir en prolongeant un peu la gravure de la matière semi-conductrice.

Un avantage essentiel du second masque 9 et surtout de ses flancs 10 est de protéger les motifs, larges 2' d'attaques latérales produites à la gravure par des réflexions du rayonnement contre lesquelles il est impossible de se prémunir et qui auraient étréci les motifs larges 2' d'une quantité difficile à prévoir : les flancs 10 garantissent donc le maintien des motifs larges 2' à la largeur voulue.

Dans ce procédé, la sélectivité des gravures, c'est-à-dire leur faculté de n'attaquer qu'un des matériaux exposés en épargnant les autres, et qui n'est que partielle en pratique, revêt une importance particulière en raison du nombre important de matériaux différents employés : les épaisseurs des masques 3 et 9 et de la couche supérieure 4 seront suffisantes pour qu'on arrive aux états illustrés pour les matériaux et les modes de gravure choisis, en veillant surtout à éviter que les reliquats tels que 3', 4' et 3'' ne disparaissent accidentellement, après une gravure excessive. En d'autres termes, la gravure de la couche semi-conductrice 2 sera assez rapide pour laisser une épaisseur suffisante des masques durs 3 et 9 aux reliquats 3' et 9''. De plus, le premier masque dur 3 doit continuer de résister même si les flancs 10 du second masque dur 9 ont disparu. Toutes ces conditions peuvent imposer des choix sur les matériaux, leurs épaisseurs et les procédés employés mais les possibilités sont assez nombreuses pour offrir des solutions.

## Revendications

1. Procédé de création d'un étage de circuit intégré comprenant des motifs, notamment semi-conducteurs, dont des premiers (2') ont des largeurs supérieures à un seuil et des seconds (2'') ont des largeurs inférieures au seuil, consistant à déposer une couche de matière (2) des motifs sur un substrat (1), un masque (3) sur la couche de matière des motifs, puis une couche supérieure (4) sur le masque, une première résine (5), qui est exposée et développée en subsistant seulement sur les premiers motifs encore à former ; à graver la couche supérieure (4) où elle est apparente, à enlever la première résine, à déposer une seconde résine (6), qui est exposée et développée en subsistant sur les seconds motifs encore à former, à graver le masque (3) où il est apparent, à graver la couche de matière (2) des motifs, formant ainsi les premiers et les seconds motifs, où elle est apparente, et à enlever la seconde résine (6) ; **caractérisé en ce qu'**il consiste encore à graver le masque (3) où il est apparent après avoir gravé la couche supérieure, à déposer un second masque (9) après avoir enlevé la première résine (5), à graver le second masque où il est apparent après avoir déposé, exposé et développé la seconde résine (6).

2. Procédé de création d'un étage de circuit intégré selon la revendication 1, **caractérisé en ce que** le second masque forme des flancs (10) autour de reliquats (3') du masque (3) déposé sur la couche de matière (2) des motifs, qui ne sont enlevés que quand la couche de matière des motifs est gravée.

3. Procédé de création d'un étage de circuit intégré selon la revendication 2, **caractérisé en ce qu'**il est réglé de façon que les premiers motifs soient formés avec une base élargie (11) sous les flancs du second masque.

4. Procédé de création d'un étage de circuit intégré selon la revendication 1, **caractérisé en ce que** la première résine (5) est exposée par un rayonnement et la seconde résine (6) est exposée par à un rayonnement de particules.

5. Procédé de création d'un étage de circuit intégré selon la revendication 4, **caractérisé en ce que** le rayonnement est lumineux et les particules sont des électrons.

6. Procédé de création d'un étage de circuit intégré selon l'une quelconque des revendications 1 à 5, **caractérisé en ce que** la seconde résine (5) est exposée par un balayage d'un faisceau.

7. Procédé de création d'un étage de circuit intégré selon l'une quelconque des revendications 1 à 6, **caractérisé en ce que** certains des premiers motifs (2') sont jointifs à certains des seconds motifs (2'').

8. Procédé de création d'un étage de circuit intégré selon l'une quelconque des revendications 1 à 7, **caractérisé en ce que** la couche supérieure (4) est en la matière des motifs et est complètement enlevée quand la couche de matière des motifs est gravée.

## Patentansprüche

1. Verfahren zur Herstellung einer Stufe einer gedruckten Schaltung mit Mustern, insbesondere von Halbleitern, von denen erste (2') Breiten aufweisen, die über einem Schwellenwert liegen, und zweite (2") Breiten aufweisen, die unter dem Schwellenwert liegen, wobei das Verfahren darin besteht, eine Materialschicht (2) von Mustern auf ein Substrat (1), eine Maske (3) auf die Muster-Materialschicht, anschließend eine obere Schicht (4) auf die Maske, eine zu belichtende und zu entwickelnde erste Harzschicht (5), wobei sie nur auf den noch zu bildenden ersten Mustern besteht, aufzubringen, die obere Schicht (4) dort, wo sie freiliegt, zu gravieren, die erste Harzschicht zu entfernen, eine zu belichtende und zu entwickelnde zweite Harzschicht (6) aufzubringen, wobei sie auf den noch zu bildenden Mustern besteht, die Maske (3) dort, wo sie freiliegt, zu gravieren, die Materialschicht (2) der Muster zu gravieren, wobei so die ersten und zweiten Muster, dort, wo sie freiliegt, gebildet werden, und die zweite Harzschicht (6) zu entfernen, **dadurch gekennzeichnet, daß** es außerdem darin besteht, die Maske (3) dort, wo sie freiliegt, zu gravieren, nachdem die obere Schicht graviert worden ist, eine zweite Maske (9) nach Entfernen der ersten Harzschicht (5) aufzubringen, und die zweite Maske dort, wo sie freiliegt, zu gravieren, nachdem die zweite Harzschicht 6 aufgebracht, belichtet und entwickelt wurde.

2. Herstellungsverfahren einer Stufe einer integrierten Schaltung nach Anspruch 1, **dadurch gekennzeichnet, daß** die zweite Maske Flanken (10) um Reste (3') der Maske (3) bildet, die auf die Muster-Materialschicht (2) aufgebracht wurde, und die erst dann entfernt werden, wenn die Muster-Materialschicht graviert ist.

3. Herstellungsverfahren einer Stufe einer integrierten Schaltung nach Anspruch 2, **dadurch gekennzeichnet, daß** sie derart geregelt ist, daß die ersten Muster mit einer verbreiterten Basis (11) unter den Flanken der zweiten Maske gebildet werden.

4. Herstellungsverfahren einer Stufe einer integrierten Schaltung nach Anspruch 1, **dadurch gekennzeichnet, daß** die erste Harzschicht (5) durch eine Strahlung belichtet wird und die zweite Harzschicht (6) durch eine Teilchenstrahlung belichtet wird.

5. Herstellungsverfahren einer Stufe einer integrierten Schaltung nach Anspruch 4, **dadurch gekennzeichnet, daß** die Strahlung eine Lichtstrahlung ist und die Teilchen Elektronen sind.

6. Herstellungsverfahren einer Stufe einer integrierten Schaltung nach einem der Ansprüche 1 bis 5, **dadurch gekennzeichnet, daß** die zweite Harzschicht (5) durch Abtasten mit einem Lichtstrahl belichtet wird.

7. Herstellungsverfahren einer Stufe einer integrierten Schaltung nach einem der Ansprüche 1 bis 6, **dadurch gekennzeichnet, daß** bestimmte erste Muster (2') neben bestimmten zweiten Mustern (2") liegen.

8. Herstellungsverfahren einer Stufe einer integrierten Schaltung nach einem der Ansprüche 1 bis 7, **dadurch gekennzeichnet, daß** die obere Schicht (4) aus dem Muster-Material besteht und vollständig entfernt wird, wenn die Muster-Materialschicht graviert wird.

## Claims

1. Process for creating an integrated circuit stage including patterns, particularly semiconductors, some first of which (2') have widths above a threshold and some second of which (2") have widths below the threshold, consisting in depositing a layer of pattern material (2) on a substrate (1), a mask (3) on the layer of pattern material, then an upper layer (4) on the mask, a first resin (5) which is exposed and developed subsisting only on the first patterns still to be formed; in etching the upper layer (4) where it is visible, in removing the first resin, in depositing a second resin (6), which is exposed and developed subsisting on the second patterns still to be formed, in etching the mask (3) where it is visible, in etching the layer of pattern material (2), thus forming the first and second patterns, where it is visible, and in removing the second resin (6); **characterized in that** it further consists in etching the mask (3) where it is visible after etching the upper layer, in depositing a second mask (9) after removing the first resin (5), in etching the second mask where it is visible after depositing, exposing and developing the second resin (6).

2. Process for creating an integrated circuit stage according to claim 1, **characterized in that** the second mask forms flanks (10) around residues (3') of the mask (3) deposited on the pattern material layer (2), which are only removed when the pattern material layer is etched.

3. Process for creating an integrated circuit stage according to claim 2, **characterized in that** it is controlled in such a way that the first patterns are formed with a broadened base (11) under the flanks of the second mask.

4. Process for creating an integrated circuit stage according to claim 1, **characterized in that** the first resin (5) is exposed by radiation and the second resin (6) is exposed by particle radiation.

5. Process for creating an integrated circuit stage according to claim 4, **characterized in that** the radiation is light radiation and the particles are electrons.

6. Process for creating an integrated circuit stage according to any one of the claims 1 to 5, **characterized in that** the second resin (5) is exposed by beam scanning.

7. Process for creating an integrated circuit stage according to any one of the claims 1 to 6, **characterized in that** some of the first patterns (2') are adjacent to some of the second patterns (2").

8. Process for creating an integrated circuit stage according to any one of the claims 1 to 7, **characterized in that** the upper layer (4) is made of the pattern material and is completely removed when the pattern material layer is etched.
